Europäisches Patentamt

(19) European Patent Office

Office européen des brevets

(11) Publication number: **0 181 171**
**A2**

(12) # EUROPEAN PATENT APPLICATION

(21) Application number: **85307949.9**

(22) Date of filing: **01.11.85**

(51) Int. Cl.⁴: **G 05 F 1/56**
**H 03 M 1/06**

(30) Priority: **09.11.84 US 670589**

(43) Date of publication of application:
**14.05.86 Bulletin 86/20**

(84) Designated Contracting States:
**DE FR GB**

(71) Applicant: **PRECISION MONOLITHICS INC.**
**1500 Space Park Drive**
**Santa Clara California 95050(US)**

(72) Inventor: **Harvey, Barry**
**1701 Holt**
**Los Altos California 94022(US)**

(74) Representative: **Crawford, Andrew Birkby et al,**
**A.A. THORNTON & CO. Northumberland House 303-306**
**High Holborn**
**London WC1V 7LE(GB)**

(54) **Fast settling reference amplifier.**

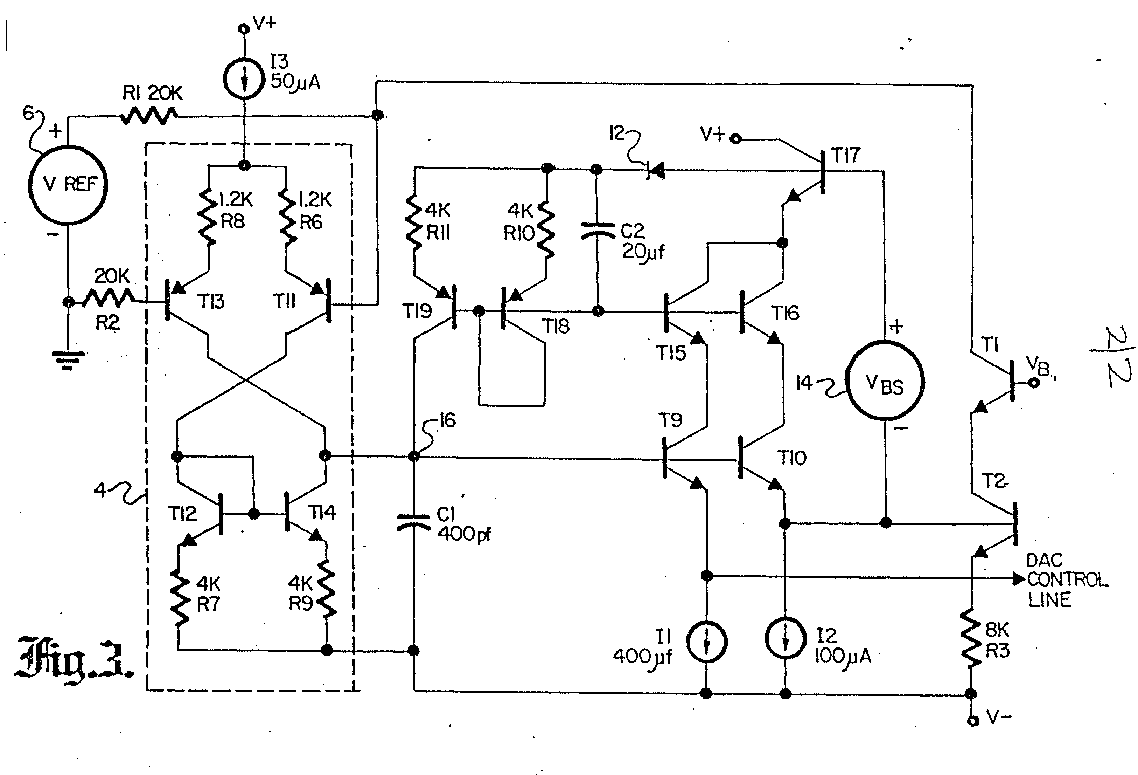

(57) A voltage reference circuit for digital-to-analog conver-
ters and the like, including an operational amplifier (4) with a
feedback transistor (T1,T2) connected in a feedback circuit. A
dual output buffer circuit is connected to the amplifier
output, with one of the buffer outputs (T9,T1) providing the
output for the reference circuit, and the other buffer output
(T10,T2) connected to the feedback transistor (T1,T2). The
two buffer outputs track each other in voltage, but substan-
tially isolate the feedback circuit from high frequency
transient signals on the reference circuit output line, thereby
inhibiting destabilization of the reference circuit. In the
preferred embodiment (Figure 4) the buffer circuit (T9, T10) is
formed from a pair of matched bipolar transistors and
associated current sources. A compensation circuit supplies
a current to the reference circuit output which is substantially
equal, but opposite in polarity, to the base current drawn by
the buffer transistors, thereby reducing the input voltage
offset. High frequency transient signals which do reach the
feedback circuit from the reference circuit output line are
mostly absorbed by capacitors in the buffer and compensa-
tion circuits.

./...

Fig.2.

0181171

This invention relates to electronic circuitry, and more particularly to voltage reference circuits used for digital-to-analog converters (DACs) and similar devices.

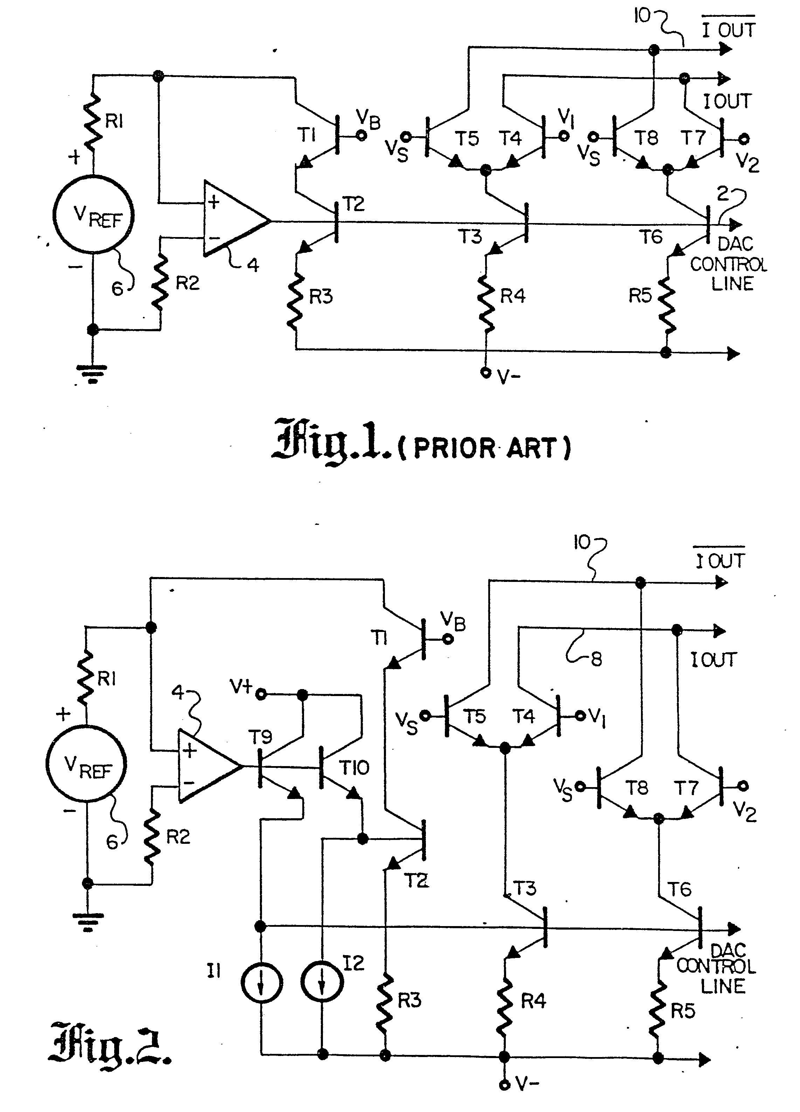

Reference voltage amplifiers have been used in DACs and other devices to set up control line voltages which govern the operation of the device. A typical application for a reference amplifier is shown in FIG. 1. In this circuit, the amplifier is being used to establish a voltage for a DAC control line 2.

The reference amplifier of FIG. 1 includes an operational amplifier 4 with a reference voltage source 6 connected through resistor R1 to its non-inverting input, and its inverting input connected through resistor R2 to ground. The non-inverting input is also connected in a feedback loop which includes a compensating transistor T1 and a feedback transistor T2, the base of which is connected to the output of operational amplifier 4. Compensating transistor T1 is designed to compensate for the current loss of the finite gain transistor switches in the DAC by losing sufficient base current into the feedback circuit to null out the error from the switching transistors.

In the implementation shown, transistors T1 and T2 are npn bipolar transistors, with the emitter of T2 connected to a negative voltage source through resistor R3. The output of amplifier 4 continues past the base of T2 to establish the DAC control line. The first two bits of a typical DAC are shown for illustration. The first bit consists of a current source transistor T3 which is matched with T2 and biased by the control line. Transistor T3 draws current through a differential switch consisting of npn transistors T4 and T5. Transistor T4 is biased by the digital input $V_1$ to the first bit of the DAC. The transistor is actuated when a signal is present at $V_1$ greater than the constant switch voltage $V_s$

applied as a bias to transistor T5, and produces an output over output line 8. Transistor T5 is actuated when $V_s$ is greater than $V_1$, and produces a complementary output signal over output line 10. The current source transistor T3 for the bit is connected through a resistor R4 to the negative voltage source.

The second DAC bit is constructed in a manner similar to the first bit, with a current source transistor T6, a resistor R5 between its emitter and the negative voltage source, and switch transistors T7 and T8. Transistor T6 is biased in common with T2 and T3 from the amplifier output, but is scaled so that its collector-emitter circuit transmits half the current of T2 or T3. Its associated switching transistor T7 is connected to the digital input of the second DAC bit such that, when actuated, it transmits a current to output line 8 equal to half the first bit current. Similarly, transistor T8 is biased by the constant switching voltage $V_s$ such that a complementary output equal to half the first bit output is applied to output line 10 when T8 is actuated.

Six or more additional bit circuits would normally be provided, each including a current source transistor which is either biased directly by control line 2, or indirectly through some form of decremented bias circuit. In operation, each of the bit switching circuits would rapidly alternate its switching mode as a digital signal is progressively applied to the various bit inputs, with each bit circuit either being "on" or "off" depending upon the magnitude of the digital signal at its corresponding input at any particular instant.

While this arrangement is generally satisfactory, it has been found that the reference amplifier can induce long settling delays as a result of digital switching. This can occur when, in the course of a digital signal being applied, the base-emitter voltages of the bit switching transistors are rapidly changed. Changes in the switching transistor emitter voltages are thus induced, and a high frequency transient current is transmitted through the base-collector capacitances of the current source transistors for the respective bits. If the output impedance of operational amplifier 4 were sufficiently low even at high frequencies, the dynamic current delivered through the bases of the bit current source transistors would not generate an error voltage of any significant consequence. However, the switching current pulse, or "glitch", is usually very fast (in the range of nanoseconds or tens of nanoseconds) and intense (as much as several hundred microamperes), and many amplifiers cannot maintain an accurate output level in the face of such glitches. The glitch can cause the DAC control line voltage to jump to a different level, thereby destabilizing the circuit. A consequence of destabilization is that the reference feedback transistor is also destabilized, forcing the entire amplifier loop to restabilize. Many amplifiers cannot settle to a quiescent level fast enough in numerous uses.

In view of the above problems associated with the prior art, it is an object of the present invention to provide a novel and improved reference amplifier with rapid settling characteristics, even in the presence of glitches on its output line.

Another object of the invention is the provision of a fast settling reference amplifier having a control output which is effectively isolated from its feedback circuit, so as to prevent glitches on the control output from interfering with the feedback operation.

In the realization of these and other objects, voltage reference circuit is provided with a dual output buffer circuit which is connected to the output of the reference amplifier. The first output of the buffer circuit provides the reference circuit output, while the second output of the buffer circuit is connected to the feedback transistor. The buffer circuit causes its two outputs to track each other in voltage, but substantially isolates its second output from high frequency transient glitches at its first output, thereby inhibiting destabilization of the reference circuit due to such transient signals.

In a preferred embodiment, the buffer circuit has first and second matched bipolar output transistors with their bases connected to the amplifier output, and a pair of current sources which direct current through the collector-emitter circuits of the output transistors. In order to reduce voltage offsets in the reference current amplifier, a compensation circuit is connected to provide a compensating current to the amplifier output which compensates for the base currents drawn by the output transistors. The compensation circuit preferably consists of transistors which are matched with and supply the current for the output transistors, and additional transistors which inject a current equal to the base currents of the matching transistors into the amplifier output. A capacitor is connected to the amplifier output to provide a low output impedance and to absorb at least part of any high frequency transient current signals which may flow through the buffer transistors as a result of glitches in the reference circuit output, and a second capacitor is connected at a corresponding location in the compensation circuit to enhance the current absorption feature.

These and other features and advantages of the invention will be apparent to those skilled in the art from the following detailed description of a preferred embodiment, taken together with the accompanying drawings, in which:

FIG. 1 is a schematic diagram of a prior art voltage reference circuit supplying the first two bits of a DAC;

FIG. 2 is a simplified schematic diagram of the voltage reference circuit of the present invention; and

FIG. 3 is a more detailed schematic diagram of the improved reference circuit.

A simplified form of the circuit for the present fast settling reference amplifier is shown in FIG. 2. In this figure, circuit elements which are common to the prior art circuit of FIG. 1 are identified by the same reference numerals.

The basic distinction from the prior art circuit is that, whereas in the prior art circuit the output of operational amplifier 4 drove both the reference feedback transistor T2 and the DAC control line 2, in the improved circuit a dual output buffer circuit is provided which causes the feedback transistor and DAC control line to be effectively isolated from each other for purposes of keeping glitches on the control line out of the feedback circuit, and to be driven separately from the reference amplifier output. The buffer circuit consists of matched npn transistors T9 and T10, the bases of both transistors being directly connected to the output of reference operational amplifier 4. Equal current sources I1 and I2 are connected to the emitters of T9 and T10, respectively, to draw current through the collector-emitter circuits of those transistors, while the transistor collectors are connected to a positive voltage bus.

T9 and T10 are connected in an emitter follower configuration, with the emitter of T9 connected to the DAC control line, and the emitter of T10 connected to the base of reference feedback transistor T2. The two transistors T9 and T10 thus isolate T2 from the DAC control line, and serve to greatly reduce the destabilizing effect on the reference amplifier of glitches on the control line. It can be seen that, to go from the DAC control line 2 to the base of T2, it is necessary to step up in voltage by the emitter-base voltage of T9, and then to step down by the base-emitter voltage of T10. Since T9 and T10 are matched and commonly biased, their base-emitter voltages will be substantially equal. In practice, the voltages at the base of T2 and on the DAC control line have been found to track each other to within a millivolt, thereby assuring that the reference amplifier operates, under the influence of its feedback circuit, to maintain the DAC control line at the correct voltage. At the same time, the isolating effect of T9 and T10 helps to prevent glitches on the DAC control line from destabilizing the feedback loop and the reference amplifier.

A more detailed presentation of the improved reference circuit, with additional features to enhance its operation, is shown in FIG. 3. In this figure the reference amplifier 4 is implemented as a typical two-branch operational amplifier. The first branch, which receives the non-inverting input, comprises a series connection of resistor R6, transistor T11, diode-connected transistor T12, and resistor R7. The other branch, which receives the non-inverting input and supplies the amplifier's output, comprises a series connection of resistor R8, transistor T13, transistor T14 having a common base connection with T12, and resistor R9. The bases of T11 and T13 are connected to resistors R1 and R2, respectively, while the amplifier output is taken from the junction between T13 and T14. R7 and R9 are connected to the negative voltage source, while a current source I3 provides current from a positive voltage source to the junction of R6 and R8.

When a glitch does occur on the DAC control line, it has been found that a small amount of glitch will generally flow through the base of T9. A capacitor C1 is provided between the base of T9 and the negative voltage source to absorb this charge transfer during the glitch.

Transistors T11, T12, T13 and T14 will typically have small operating currents to minimize input offset voltages and bias currents, whereas buffer transistors T9 and T10 are typically biased at considerably higher currents to provide low output impedance at the control line. For example, if I3 is 50 microamps, I1 and I2 might be 500 microamps. Since T9 and T10 are connected to one of the two reference amplifier branches, their relatively high base currents will induce a voltage offset at the amplifier input. With current sources operating as the values described in the example given immediately above, and assuming an npn transistor gain of about 100, T9 and T10 can produce on the order of 10 millivolts of input offset voltage.

To mitigate the effects of the base currents of T9 and T10, a compensation circuit is provided to inject a compensating current back to the reference amplifier output which effectively nulls out the base current drawn by T9 and T10. This compensation circuit includes a pair of transistors T15 and T16 which are matched with and connected in series with T9 and T10, respectively, so that the collector-emitter currents through T15 and T16 are approximately equal to those through T9 and T10. The current through T15 and T16 is supplied from the emitter of another npn transistor T17. A diode-connected pnp transistor T18 is connected to the same bias line as T15 and T16, and provides a collector current which supplies the base currents of those two transistors. T18 is supplied with current from the base of T17 through diode 12 and resistor R10. The current through T18, which is approximately equal to the combined base currents of T15 and T16, is mirrored by another pnp transistor T19. The emitter of T19 is connected through resistor R11 to a common current input with R10, while its collector is connected to the reference amplifier output at node 16. The current supplied by the collector of T19 is substantially equal to the combined base currents of T15 and T16, which in turn are substantially equal to the combined base currents of T9 and T10. In this manner the voltage offset effect of T9 and T10 on the reference amplifier is substantially cancelled by the compensation circuit.

Transistors T15, T16, T18 and T19 are all bootstrapped by means of a bootstrap voltage source 14 which is connected between the emitter of T10 and the base of T17, the collector of the latter transistor being connected to the positive voltage source. In this manner transistors T9, T10, T15 and T16 all have substantially equal collector-emitter voltages, with a concomitant improvement in base current compensation and overall amplifier gains.

The compensation circuit also adds an extra degree of stabilization to the reference amplifier. Capacitor C2 is connected between the base of transistor T15 and the cathode of diode 12. When a glitch appears on the DAC control line, causing capacitor C1 to absorb the small amount of transient current which flows through the base of Q5, the voltage on C1 will change slightly. This has a slight destabilizing effect, making it necessary for the entire feedback loop to restabilize. With the addition of the compensation circuit, the base of T15 will experience a pulse about the same charge as the base of T9. This charge is very rapidly absorbed by C2, and more slowly reversed by T18 and T19 and re-applied to C1, thus negating much of the charge error before the amplifier loop has had an opportunity to destabilize to any significant degree. The addition of C2 can provide approximately a three-fold reduction of dynamic error as compared to the operation of C1 without C2.

While a particular embodiment of the invention has been shown and described, various modifications and alternate embodiments will occur to those skilled in the art. Accordingly, it is intended that the invention be limited only in terms of the appended claims.

CLAIMS:

1. . A voltage reference circuit for applying a stabilized voltage signal to a voltage control line, comprising:

a voltage reference source (6),

an amplifier (4) connected to amplify the output of the voltage reference source (6),

a feedback circuit (T1,T2) connected in circuit with the amplifier (4), and

a dual output buffer circuit connected to the output of the amplifier (4), the first buffer circuit output (T9,I1) interfacing between the amplifier output and the control line, and the second buffer circuit output (T10,I2) interfacing between the amplifier output and the feedback circuit, said buffer circuit causing its two outputs to track each other in voltage, but substantially isolating its second output from high frequency transient signals on the control line, and thereby inhibiting destabilization of the reference circuit due to said transient signals.

2. The voltage reference circuit of claim 1, said buffer circuit comprising first and second matched bipolar output transistors (T9,T10) having their bases connected to the amplifier output, and a pair of current sources (I1,I2) directing current through the collector-emitter circuits of the output transistors, respectively, the collector-emitter circuit of the first output transistor (T9) being connected to the control line, and the collector-emitter circuit of the second output transistor (T10) being connected to the feedback circuit.

3. The voltage reference circuit of claim 2, further comprising a capacitor (C1) connected to the amplifier output to provide a low output impedance and to absorb at least part of any high frequency transient current signals which flow through the base of the first output transistor (T9) from the control line.

4. The voltage reference circuit of claim 2, said amplifier (4) comprising a plurality of transistors (T11,T12,T13,T14) connected in a pair of branches, the buffer circuit output transistors (T9,T10) being supplied with base current by one of the branches (T11,T12) and thereby producing an amplifier voltage offset, and further comprising a compensation

circuit (12,14,T15,T16,T17,T18,T19,C2,R10,R11) connected to provide a compensating current to the amplifier output to compensate for the output transistor base currents.

5. The voltage reference circuit of claim 4, said compensation circuit comprising third and fourth transistors (T15,T16) matched with the first and second transistors (T9,T10) and having their collector-emitter circuits connected to supply the collector-emitter currents of the first and second transistors, respectively, a fifth transistor (T18) connected to supply the base currents of the third and fourth transistors, and a sixth transistor (T19) connected to mirror the current supplied by the fifth transistor, and to inject its current into the amplifier output.

6. The voltage reference circuit of claim 5, further comprising a bootstrap voltage source (14) connected to bootstrap the third (T15), fourth (T16), fifth (T18) and sixth (T19) transistors so that the first, second, third and fourth transistor collector-emitter voltages are substantially equal.

7. The voltage reference circuit of claim 5, further comprising a capacitor (C2) connected to the base of the third output transistor (T15) for absorbing at least part of any high frequency transient current signals which flow from the first output transistor (T9) to the base of the third transistor (T15).

8. The voltage reference circuit of claim 7, further comprising a capacitor (C1) connected to the amplifier (4) output to provide a low output impedance and to absorb at least part of any high frequency current signals which flow through the base of the first output transistor (T9) from the control line.

0181171

**Fig.1.(PRIOR ART)**

**Fig.2.**

Fig. 3.

0181171